# EUROPEAN PATENT APPLICATION

(11) **EP 4 746 294 A1**
(43) Date of publication of application: **20.05.2026**
(21) Application number: 25211110.9
(22) Date of filing: 24.10.2025
(51) Int. Cl.: H03K 3/356

(54) **STRESS-TOLERANT SEMICONDUCTOR DEVICE AND LEVEL SHIFTER**

(30) Priority: 13.11.2024 CN 202411620591
(71) Applicant: NXP B.V., 5656 AG Eindhoven (NL)
(72) Inventor: Zhang, Yizhong, 5656AG Eindhoven (NL); Jin, Jie, 5656AG Eindhoven (NL); Mo, Yikun, 5656AG Eindhoven (NL); Ma, Yan, 5656AG Eindhoven (NL)
(74) Representative: Colaiuda, Antonella

(57) **Abstract**

There is provided a stress-tolerant semiconductor device (300, 400), a level shifter (500, 600) comprising the same, and a power switch (800) controlled by the level shifter. The stress-tolerant semiconductor device (300, 400) comprises: a source terminal (302, 402), a gate terminal (304, 404), a gate-control terminal (306, 406), and a drain terminal (308, 408); a first transistor (310, 410) having a source (320, 420) connected to the source terminal (302, 402), a gate (322, 422) connected to the gate terminal (304, 404), and a drain (324, 424); a second transistor (312, 412) having a source (326, 426) connected to the drain (324, 424) of the first transistor (310, 410), a gate (328, 428) connected to the gate-control terminal (306, 406), and a drain (330, 430); a third transistor (314, 414) having a source (332, 432) connected to the drain (330, 430) of the second transistor (312, 412), a drain (336, 436) connected to the drain terminal (308, 408), and a gate (334, 434); a fourth transistor (316, 416) having a drain (338, 438) connected to the gate-control terminal (306, 406), a gate (340, 440) connected to the drain terminal (308, 408), and a source (342, 442); and a fifth transistor (318, 418) comprising a source (344, 444) connected to the source (342, 442) of the fourth transistor (316, 416), a gate (346, 446) connected to the gate-control terminal (306, 406), and a drain (348, 448) connected to the drain terminal (308, 408); wherein a conductivity type of said first, second and third transistors (310, 410, 312, 412, 314, 414) is opposite to a conductivity type of said fourth and fifth transistors (316, 416, 318, 418).

## Description

### FIELD

The present disclosure relates to a stress tolerant semiconductor device and a level shifter. In particular, but not exclusively, the present disclosure relates to a stress-tolerant MOS device, and a stress-tolerant level shifter comprising the same.

### BACKGROUND

Semiconductor processes for the digital domain have been scaled down to meet high speed and low power requirements. The supply voltage (VDD) and voltage tolerance of such devices has reduced accordingly. However, for legacy and compatibility reasons, today's SOC (system on chip) designs still need to support higher voltage (nVDD) interfaces than the voltage supported by the manufacturing process. For reliability (lifetime) considerations, designs for analog control should be stress tolerant while using the standard VDD digital process. As an example 1.8V I/O (input/output) devices are widely used, whereas interfaces to higher voltages such as 3V/5V are important for some applications.

Level shifters are used to interface control between different voltage domains, and, as key building block, should balance reliability, compatibility, flexibility and performance. For a complex system, hundreds of level shifters may be required, so die size and leakage current are important.

Although "stress tolerant level shifters" are available, these all support a mode in which logic "0" signals are converted from GND to (n-1)VDD and logic "1" signals are converted from VDD to nVDD. However, none of them support a mode in which logic "0" signals are converted from GND to GND and logic "1" signals are converted from VDD to nVDD. ADC "Bootstrapped switch" are one important family, but require "clock to control" and differ from the present disclosure both at the mechanism level and in terms of applications.

### SUMMARY

Features of the invention are set out in the appended claims.

According to a first aspect, there is provided a stress tolerant semiconductor device, comprising: a source terminal, a gate terminal, a gate-control terminal, and a drain terminal; a first transistor having a source connected to the source terminal of the stress-tolerant device, a gate connected to the gate terminal of the stress-tolerant device, and a drain; a second transistor having a source connected to the drain of the first transistor, a gate connected to the gate-control terminal of the stress-tolerant device, and a drain; a third transistor having a source connected to the drain of the second transistor, a drain connected to the drain terminal of the stress-tolerant device, and a gate; a fourth transistor having a drain connected to the gate-control terminal of the stress-tolerant device, a gate connected to the drain terminal of the stress-tolerant device, and a source; and a fifth transistor comprising a source connected to the source of the fourth transistor, a gate connected to the gate-control terminal of the stress-tolerant device, and a drain connected to the drain terminal of the stress-tolerant device; wherein a conductivity type of said first, second and third transistors is opposite to a conductivity type of said fourth and fifth transistors.

In some embodiments, the first, second and third transistors of the stress-tolerant device are PMOS transistors, and the fourth and fifth transistors of the stress-tolerant device are NMOS transistors.

In some embodiments, the first, second and third transistors of the stress-tolerant device are NMOS transistors, and the fourth and fifth transistors of the stress-tolerant device are PMOS transistors.

According to a second aspect of the invention, there is provided a level shifter comprising at least one stress-tolerant semiconductor device according to the first aspect defined above.

In some embodiments, the level shifter may comprise: two input nodes; two first output nodes; two second output nodes; a first pair of cross-coupled semiconductor devices, each having a source terminal coupled to a high-voltage supply line, each having a drain terminal coupled to a respective one of the two first output nodes, and each having a gate terminal coupled to a respective other of the two first output nodes; a second pair of semiconductor devices each having a source terminal coupled to a respective one of the two first output nodes, each having a gate terminal coupled to the gate terminal of the other one of the second pair of semiconductor devices, and each having a drain terminal coupled to a respective one of the two second output nodes; and a third pair of semiconductor devices, each having a drain terminal coupled to a respective one of the two second output nodes, each having a source terminal coupled to a reference potential, and each having a gate terminal coupled to a respective one of the two input nodes; wherein each one of the second pair of semiconductor devices and each one of the third pair of semiconductor devices comprises a stress-tolerant device according to the first aspect defined above.

In some embodiments, the level shifter may comprise: two input nodes; two first output nodes; two second output nodes; a first pair of cross-coupled semiconductor devices, each having a source terminal coupled to a high-voltage supply, each having a drain terminal coupled to a respective one of the two first output nodes, and each having a gate terminal coupled to a respective other of the two first output nodes; a second pair of semiconductor devices each having a source terminal coupled to a respective one of the two first output nodes, and each having a drain terminal coupled to a respective one of the two second output nodes; and a third pair of semiconductor devices, each having a drain terminal coupled to a respective one of the two second output nodes, each having a source terminal coupled to a reference potential, and each having a gate terminal coupled to a respective one of the two input nodes; wherein each one of the second pair of semiconductor devices and each one of the third pair of semiconductor devices comprises at least one stress-tolerant device according to the first aspect defined above.

In some embodiments, each one of the second pair of semiconductor devices comprises a plurality of stress-tolerant devices according to the first aspect.

In some embodiments, the drain terminal of each one of the second pair semiconductor devices is provided by the drain terminal of a first one of the respective plurality of stress-tolerant devices; the drain terminal of each next one of the respective plurality of stress-tolerant devices is coupled to the source terminal of the respective preceding one of the respective plurality of stress-tolerant devices; and the source terminal of each one of the second pair semiconductor devices is provided by the source terminal of a last one of the respective plurality of stress-tolerant devices.

In some embodiments, the gate terminal of each said at least one stress-tolerant device of each of said second pair of semiconductor devices is coupled to the gate-control terminal of the respective stress-tolerant device.

In some embodiments, the gate terminal of each one of said at least one stress-tolerant device of one of said second pair of semiconductor devices is coupled to the gate terminal of a corresponding stress-tolerant device of the other one of said second pair of semiconductor devices.

In some embodiments, said first, second and third transistors of each said stress-tolerant device of the second pair of semiconductor devices are PMOS transistors, and said fourth and fifth transistors of each said stress-tolerant device of the second pair of semiconductor devices are NMOS transistors.

In some embodiments, said first, second and third transistors of each said stress-tolerant device of the third pair of semiconductor devices are NMOS transistors, and said fourth and fifth transistors of each said stress-tolerant device are PMOS transistors.

In some embodiments, each one of the first pair of semiconductor devices comprises a stress-tolerant device according to the first aspect defined above.

In some embodiments, the first, second and third transistors of each said stress-tolerant device of the first pair of semiconductor devices are PMOS transistors, and said fourth and fifth transistors of each said stress-tolerant device of the first pair of semiconductor devices are NMOS transistors.

In some embodiments, each one of the first pair of semiconductor devices is a PMOS transistor.

In some embodiments, the level shifter further comprises at least one output coupled to a respective one of the two first output nodes or a respective one of the two second output nodes.

In some embodiments, the level shifter further comprises: an input circuit coupled between a low voltage supply and the reference potential, configured to receive a first input signal having a first state corresponding to the potential of the reference potential and a second state corresponding to the potential of the low voltage supply line, and to generate a second input signal having a respective first state corresponding to the potential of the low voltage supply and a respective second state corresponding to the reference potential; wherein one of said two input nodes is arranged to receive the first input signal, and the other one of said two input nodes is configured to receive the second input signal.

In some embodiments, the level shifter further comprises a control circuit for generating one or more control voltages, wherein a respective gate-control terminal of each of said stress-tolerant semiconductor devices is arranged to receive one or said one or more control voltages.

In some embodiments, the level shifter further comprises a multiplexer arranged to receive said one or more control voltages, and to output a respective selected one of said one or more control voltages to the respective gate-control terminal of each said stress-tolerant semiconductor devices.

In some embodiments, the gate-control terminal of each one of the first pair of semiconductor devices is arranged to receive a voltage corresponding to a difference between the voltage of the high voltage supply and the voltage of the low voltage supply.

In some embodiments, the gate-control terminal of each one of the first pair of semiconductor devices is arranged to receive a voltage corresponding to half of the voltage of the high voltage supply.

In some embodiments, a respective gate-control terminal of each one of the third pair of semiconductor devices is arranged to receive a voltage corresponding to the low voltage supply.

In some embodiments, wherein each one of the second pair of semiconductor devices comprises a plurality of stress-tolerant devices according to the first aspect, a gate-control terminal of the first one of the plurality of stress-tolerant devices is arranged to receive a voltage corresponding to the low voltage supply; and/or a gate-control terminal of a last one of the plurality of stress-tolerant devices is arranged to receive a voltage corresponding to a difference between the voltage of the high voltage supply and a voltage of the low voltage supply. In some embodiments, a respective gate-control terminal of each one of the second pair of semiconductor devices and/or the third pair of semiconductor devices is arranged to receive a voltage corresponding to the low voltage supply.

In some embodiments, the level shifter further comprises the respective gate-control terminal of each one of the first pair of semiconductor devices and/or at least one gate-control terminal of each one of the second pair of semiconductor devices is coupled to the reference potential, and/or wherein the respective gate-control terminal of each one of the third pair of semiconductor devices and/or the third pair of semiconductor devices is arranged to receive a voltage corresponding to the low voltage supply.

According to a third aspect of the present disclosure, there is provided a power switch comprising: an NMOS power transistor; and a level shifter according to the second aspect defined above; wherein a gate of the power transistor is coupled to one of the two second output nodes.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures.
Figure 1 schematically illustrates an example level shifter;
Figure 2 schematically illustrates another example level shifter;
Figure 3 schematically illustrates a stress-tolerant NMOS semiconductor device according to an example embodiment of the present disclosure;
Figure 4 schematically illustrates a stress-tolerant PMOS semiconductor device according to an example embodiment of the present disclosure;
Figure 5 schematically illustrates a level shifter according to an example embodiment of the present disclosure;
Figure 6 schematically illustrates a level shifter according to another example embodiment of the present disclosure;
Figure 7 schematically illustrates a level shifter according to a further example embodiment of the present disclosure and
Figure 8 schematically illustrates a power switch controlled by the level shifter of any one of Figures 5, 6 or 7, according to an example embodiment of the present disclosure.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

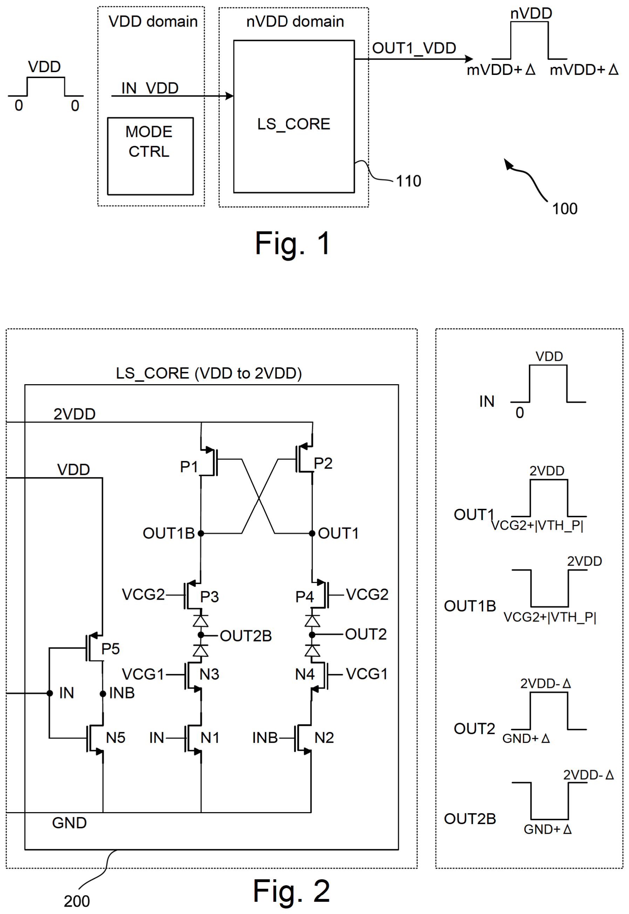

Figure 1 illustrates an example level shifter 100, useful for understanding the present disclosure, for level-shifting an input signal IN_VDD from a low voltage (VDD) domain to an output signal OUT1_nVDD in a high voltage (nVDD) domain. The level shifting is achieved by block LS_CORE in the high voltage (nVDD) domain. The supply voltage in the low voltage (VDD) domain has a value VDD. The supply voltage in the high voltage (nVDD) domain has a value nVDD = n*VDD. The input signal IN_VDD has a logic "0" value of 0 (i.e., the ground GND or reference potential) and a logic "1" value of VDD, while the output signal OUT1_VDD of the level shifter 100 has a logic "0" value of m*VDD+Δ and a logic "1" value of nVDD, where the Δ represents an allowable variation in the supply voltage. In this prior art example, n>m, n≥2, and n-m≥1. The MODE CTRL block is used for control the mode of operation of the level shifter 100, such as Power on Reset (POR) mode, isolation (ISO) mode, voltage clamp mode, etc.

Note that "VDD" and "nVDD" represent the specified voltages for the low-voltage and high-voltage domains respectively, not the real voltages.

Figure 2 illustrates another level shifter 200 as an example of the block LS_CORE of Figure 1. In this example, the high voltage nVDD is taken to be 2VDD, i.e., 2*VDD. The level shifter 200 includes a first pair of cross-coupled PMOS transistors P1, P2, each having a source connected to a high-voltage supply line 2VDD, a drain connected to a respective one of two output nodes OUT1B, OUT1, and a gate connected to a respective other of the two first output nodes OUT1, OUT1B. The level shifter 200 further includes a second pair of PMOS transistors P3, P4, each having a source connected to a respective one of the two first output nodes OUT1, OUT1B, and a gate connected to the gate of the other one of the second pair of PMOS transistors P3, P4 and to a control voltage VCG2. The drain of each of the second pair of PMOS transistors P3, P4 is coupled to a respective further output node OUT2B, OUT2 via a respective diode. The level shifter 200 further includes a first pair of NMOS transistors N3, N4 each having a drain coupled to a respective one of the two further output nodes OUT2B, OUT2 via a respective further diode, and a gate connected to the gate of the other one of the first pair of NMOS transistors N3, N4 and to a control voltage VCG1. The level shifter 200 further include a second pair of NMOS transistors N1, N2, each having a drain connected to the source of a respective one of the first pair of NMOS transistors N3, N4, each having a source connected to ground GND, and each having a gate coupled to a respective one of two input nodes IN, INB.

The level shifter 200 further includes an input circuit comprising a PMOS transistor P5 and an NMOS transistor N5. The PMOS transistor P5 has a source coupled to the low voltage supply line VDD, a gate coupled to receive the input signal from the first input node IN, and a drain coupled to the second input node INB. The NMOS transistor N5 has a drain coupled to the second input node INB, a source coupled to the ground GND, and a gate coupled to receive the input signal from the first input node IN.

In a first state (e.g., logic level "0"), the first input node IN is at the ground voltage GND, and the second input node is therefore at the low voltage supply potential VDD. As a result, the NMOS transistors N2 and N4 turn on. The PMOS transistor P4 acts as a voltage clamp, such that the voltage at the first output node OUT1 is VCG2 + |VTH_P|. The first output node OUT 1 is connected to the gate of the PMOS transistor P1, so transistor P1 turns on, so the drain of transistor P1 (and thus at the other output node OUT1B) is pulled up to high voltage supply potential 2VDD.

In a second state (e.g., logic level "1"), the first input node IN is at the low voltage supply potential VDD, and the second input node is therefore at the ground potential GND. As a result, the NMOS transistors N1 and N3 turn on. The PMOS transistor P3 acts as a voltage clamp, such that the voltage at the second output node OUT1B is VCG2 + |VTH_P|. The second output node OUT 1B is connected to the gate of the PMOS transistor P2, so transistor P2 turns on, and the drain of transistor P2 (and thus at the first output node OUT1) is pulled up to high voltage supply potential 2VDD.

The level shifter 200 shown in Figure 2 has some limitations. For a specified value of VDD, the actual voltage VDD is allowed to vary by up to 10%. Thus, for a nominal "VDD" of 1.8V, the actual voltage VDD would have a value in the range 1.71V to 1.98V, while for a nominal "2VDD" of 3.0V or 3.3V, the actual voltage 2VDD would be in the range from 2.7V to 3.63V. Considering the "worst case" PVT (pressure, voltage, temperature) conditions, that is, small voltage difference (e.g., VDD=1.98V, 2VDD=2.7V), SS corner and cold temperature, the pull-up ability of the PMOS transistors in the LS_CORE 110, 200 is very weak. As a result, the level shifter may itself fail (note that the PMOS transistors require on threshold voltage Vth_P to work) or the conversion time may be very long. Alternatively, if the level shifter 200 were used to control an external PMOS transistor, the external PMOS transistor may fail to turn on. This is due to the fact that the gated PMOS transistor would require an additional VTH_P (the PMOS threshold voltage) to turn on, while the worst case value of 2VDD-VDD is 2.7-1.98=0.72V, which is not sufficient to meet the two VTH_P requirement. Thus, under some conditions, the level shifter 200 has been found to fail (i.e., voltage conversion function fail) or fails to control an external PMOS device.

To overcome the above problem, one might consider using low-threshold-voltage devices in the level shifter 200. However, under the conditions of large voltage difference (e.g., VDD=1.71V, 2VDD=3.63V), FF corner and high temperature, the level shifter 200 would suffer from high leakage currents, which is undesirable in a low power design.

Another issue is that, to reduce design cost, the design should be reused in a wide range of applications. This is important as the level shifter may be a key control component, and some products may include many level shifters. However, the level shifter 200 only supports larger voltage differences, and can only support the case VDD to nVDD for n>1. That is, the level shifter 200 cannot be used in an n=1 design, for example a "VDD=2VDD in the range 1.71 to 1.98 V" design.

Finally, the level shifter 200 only supports the mode in which logic "0" is converted from GND to VDD and logic "1" is converted from VDD to 2VDD. The level shifter 200 cannot support a mode in which logic "0" is converted from GND to GND and logic "1" is converted from VDD to 2VDD, as will be explained. Considering the voltage VCG2, it is necessary to balance the requirements of device voltage tolerance and design function/performance. If VCG2 were to be set such that VCG2=VDD, then for the level shifter to work, the condition 2*|VTH_P|<VDD-Δ must be met for all PVT (process, voltage and temperature conditions), which is very hard to guarantee. For this reason, VCG2 must be lower than VDD, for example VCG=VDD-|VTH_P|. However, if OUT2=2VDD, the gate-drain voltage Vgs_P4 of PMOS transistor P4 would be Vgd_P4=VDD-|VTH_P|-2VDD = - (VDD+|VTH_P|), which would damage the PMOS transistor P4. For this reason, a complex "voltage shift" is included, represented here by a diode rather than the real circuit. Assuming the diode junction voltage is Δ, the voltage range supported by OUT2 and OUT2B is only GND+Δ to 2VDD-Δ. This voltage range is not useful due to larger leakage currents and larger turn-on resistance. Accordingly, it can be seen that the level shifter 200 can only support a mode in which logic "0" signals are converted from GND to (n-1)VDD and logic "1" signals are converted from VDD to nVDD. However, the level shifter 200 cannot support a mode in which logic "0" signals are converted from GND to GND and logic "1" signals are converted from VDD to nVDD.

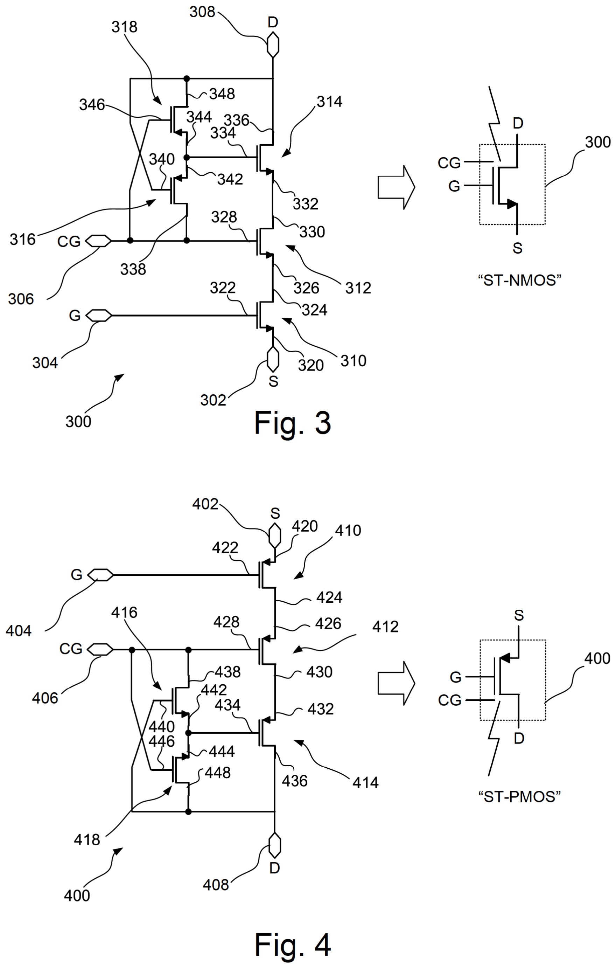

Figure 3 illustrates a stress-tolerant semiconductor device 300, in the form of a stress-tolerant NMOS semiconductor device 300, according to an example embodiment of the present disclosure. The stress tolerant NMOS semiconductor device 300 (hereinafter "ST-NMOS device") comprises a source terminal, S, 302, a gate terminal, G, 304, a gate-control terminal, CG, 306, and a drain terminal, D, 308. The ST-NMOS device 300 further comprises a first transistor 310, a second transistor 312, a third transistor 314, each in the form of an NMOS transistor. The ST-NMOS device 300 further comprises a fourth transistor 316 and a fifth transistor 318, each in the form of a PMOS transistor. That is, the conductivity type (N) of the first, second and third transistors 310, 312, 314 is opposite to the conductivity type (P) of the fourth and fifth transistors 316, 318. The first (NMOS) transistor 310 has a source 320 connected to the source terminal S, 302, of the stress-tolerant device 300, a gate 322 connected to the gate terminal, G, 304, of the ST-NMOS device 300, and a drain 324. The second (NMOS) transistor 312 has a source 326 connected to the drain 324 of the first transistor 310, a gate 328 connected to the gate-control terminal, CG, 306, of the ST-NMOS device 300, and a drain 330. The third (NMOS) transistor 314 has a source 332 connected to the drain 330 of the second transistor 312, a gate 334, and a drain 336 connected to the drain terminal, D, 308 of the ST-NMOS device 300. The fourth (PMOS) transistor 316 has a drain 338 connected to the gate-control terminal, CG, 306 of the ST-NMOS device 300, a gate 340 connected to the drain terminal, D, 308 of the ST-NMOS device 300, and a source 342. The fifth transistor 318 has a source 344 connected to the source 342 of the fourth transistor 316, a gate 346 connected to the gate-control terminal, CG, 306 of the ST-NMOS device 300, and a drain 348 connected to the drain terminal, D, 308 of the ST-NMOS device.

As an example of the operation of the ST-NMOS device 300 shown in Figure 3, consider the case in which the gate (G) terminal 304 of the ST-NMOS device 300 receives an input signal from the low voltage (VDD) domain, and the gate-control (CG) terminal 306 is connected to the low voltage supply line VDD.

If the drain terminal, D, 308 is connected to a low voltage (i.e., less than or equal to VDD), each of the first to fifth transistors 310, 312, 314, 316, 318 are safe. The fourth (PMOS) transistor 316 receives the voltage VDD at its gate 340, and is therefore turned on. The second (NMOS) and third (NMOS) transistors 312, 314 are also turned on and are therefore shorted to the drain (D) terminal 308. In this scenario, the second (NMOS) and third (NMOS) transistors 312, 314 act as a clamp, and the effect is simply to waste 2*Vdsat (i.e., 2* the drain-source voltage at saturation) of voltage headroom. Therefore, the ST-NMOS device 300 can be used to replace a normal NMOS transistor in a conventional design circuit in order to achieve a voltage-stress tolerant design, albeit with a 2*Vdsat reduction in voltage room. However, compared to the advantage of improving the voltage-stress, the 2*Vdsat reduction in headroom can be ignored.

Now consider the ST-NMOS device 300 when the drain terminal, D, 308 is connected to a high voltage (i.e., a voltage higher than VDD). As an example, we will consider the drain terminal, D, 308 being connected to a voltage 2VDD. The fifth (PMOS) transistor 318 then has its gate 346 at voltage VDD and its drain 348 at voltage 2VDD, and is turned on. As a result, the third (NMOS) transistor 314 has both its gate 334 and drain 336 connected to voltage 2VDD, and is effectively in a diode configuration. The source 332 of the third (NMOS) transistor 314 is thus 2VDD - |VTH_N|. At the same time, the gate 340 of the fourth (PMOS) transistor 316 is at voltage 2VDD and is turned off. The source 326 of the second (NMOS) transistor 312 is clamped at VDD-|VTH_N|. The result is that the Vds of the second (NMOS) transistor 312 is 2VDD-|VTH_N|-(VDD-|VTH_N|)=VDD and is therefore in the safe range. All the other transistors remain at safe voltages too.

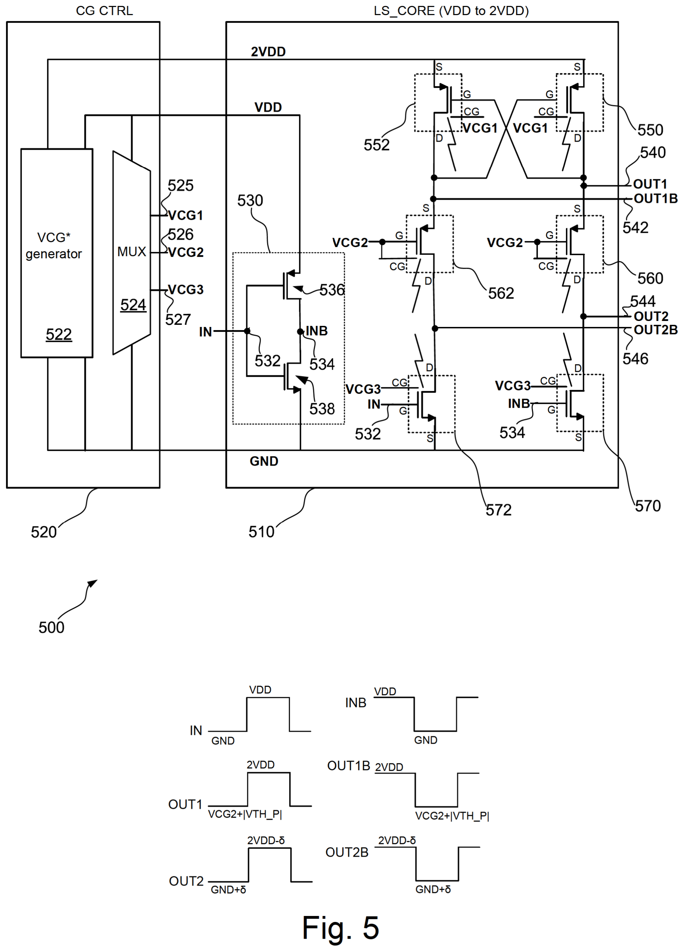

Thus, in a voltage-stress design, the ST-NMOS device 300 can be used to replace a normal NMOS transistor , without needing to consider the stress risk. In Figure 3, to the right-hand side of the schematic illustration of the ST-NMOS device 300, there is shown a symbol for the ST-NMOS device 300 described above, in which the terminals labelled D, CG, G and S correspond to the drain (D) terminal 308, gate-control (CG) terminal 306, gate (G) terminal 304 and source (S) terminal 302 of the ST-NMOS device 300 respectively. This symbol will be used in Figures 5 to 7 to represent the ST-NMOS device 300.

For clarity, the body electrodes of the transistors are not shown in Figure 3. The body electrode connections may be determined on a case-by-case basis taking account of the process and design target. For this reason, a body terminal is not is not included in the ST-NMOS symbol.

Figure 4 illustrates another stress-tolerant semiconductor device 400, in the form of a stress-tolerant PMOS semiconductor device 400, according to an example embodiment of the present disclosure. The stress tolerant PMOS semiconductor device 400 (hereinafter "ST-PMOS device") comprises a source terminal, S, 402, a gate terminal, G, 404, a gate-control terminal, CG, 406, and a drain terminal, D, 408. The ST-PMOS device 400 further comprises a first transistor 410, a second transistor 412, a third transistor 414, each in the form of an PMOS transistor. The ST-PMOS device 400 further comprises a fourth transistor 416 and a fifth transistor 418, each in the form of an NMOS transistor. That is, the conductivity type (P) of the first, second and third transistors 410, 412, 414 is opposite to the conductivity type (N) of the fourth and fifth transistors 416, 418. The first (PMOS) transistor 410 has a source 420 connected to the source terminal S, 402, of the stress-tolerant device 400, a gate 422 connected to the gate terminal, G, 404, of the ST-PMOS device 400, and a drain 424. The second (PMOS) transistor 412 has a source 426 connected to the drain 424 of the first transistor 410, a gate 428 connected to the gate-control terminal, CG, 406, of the ST-PMOS device 400, and a drain 430. The third (PMOS) transistor 414 has a source 432 connected to the drain 430 of the second transistor 412, a gate 434, and a drain 436 connected to the drain terminal, D, 408 of the ST-PMOS device 400. The fourth (NMOS) transistor 416 has a drain 438 connected to the gate-control terminal, CG, 406 of the ST-PMOS device 400, a gate 440 connected to the drain terminal, D, 408 of the ST-PMOS device 400, and a source 442. The fifth transistor 418 has a source 444 connected to the source 442 of the fourth transistor 416, a gate 446 connected to the gate-control terminal, CG, 406 of the ST-PMOS device 400, and a drain 448 connected to the drain terminal, D, 408 of the ST-PMOS device.

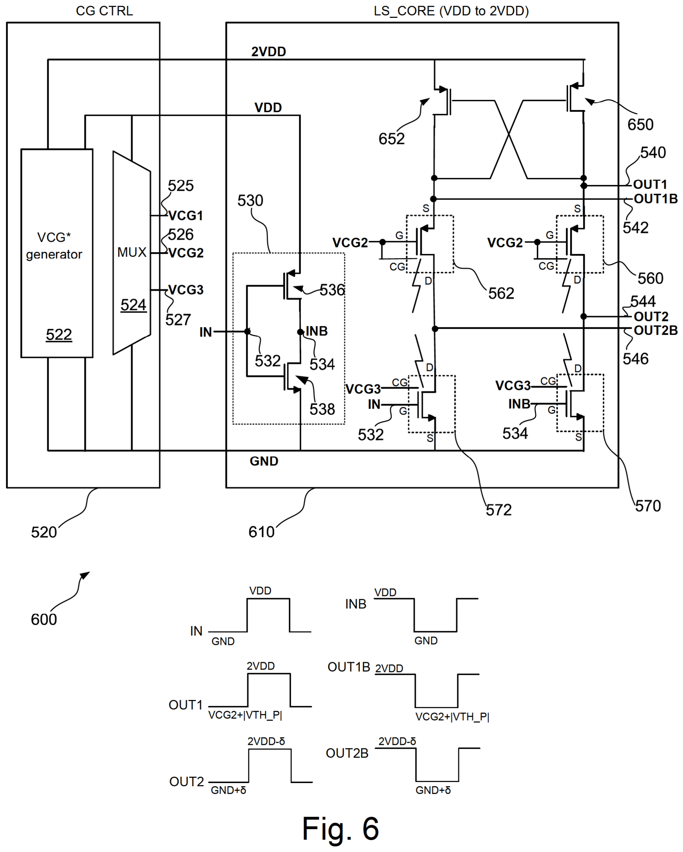

As discussed above for the corresponding ST-NMOS device 300, the ST-PMOS device 400 can similarly be used to replace a normal PMOS transistor , without needing to consider the stress risk. In Figure 4, to the right-hand side of the schematic illustration of the ST-PMOS device 400, there is shown a symbol for the ST-PMOS device 400 described above, in which the terminals labelled D, CG, G and S correspond to the drain (D) terminal 408, gate-control (CG) terminal 406, gate (G) terminal 404 and source (S) terminal 402 of the ST-PMOS device 400 respectively. This symbol will be used in Figures 5 and 6 to represent the ST-PMOS device 400.

For clarity, the body electrodes of the transistors are not shown in Figure 4. The body electrode connections may be determined on a case-by-case basis taking account of the process and design target. For this reason, a body terminal is not is not included in the ST-PMOS symbol.

Although the use of the ST-NMOS device 300 and ST-PMOS device 400 will be demonstrated below in the context of stress-tolerant level shifters with reference to Figures 5 and 6, it is to be understood that the stress-tolerant semiconductor devices 300, 400 described above can be used in any suitable system or application. Each of the stress-tolerant semiconductor devices 300, 400 may be stacked in series as required to provide tolerance to even higher voltages.

Figure 5 schematically illustrates a level shifter 500 according to an example embodiment of the present disclosure. The level shifter 500 comprises a core circuit LS_CORE 510 for level shifting an input signal IN 530 from a low voltage (VDD) domain to a high voltage (nVDD) domain, and a control circuit CG_CTRL520 for generating the gate-control voltages VCG1 525, VCG2 526, and VCG3 527 for the core circuit LS_CORE 510. The embodiment shown in Figure 5 is shown as a VDD to 2VDD level shifter, i.e., n=2. However, this is by way of example only, and the skilled person will appreciate that the level shifter of the present disclosure is applicable to other values of n, for example n=3, n=4, etc. For completeness, we also note that n may take any value and is not restricted to integer values.

The control circuit CG_CTRL 520 comprises a VCG generator 522 for generating the required voltages, and a multiplexer 524 for selecting from between the voltages generated by the VCG generator 522 for output to the core circuit LS_CORE 510. As an example, voltages provided by the VCG generator 522 may include one or more of the following: "2VDD"/2, ("2VDD"/2 ± Δ1), VDD, VDD ± Δ2, GND, and/or other options (with Δ1, Δ2 representing the tolerance window of the supply voltages. The control voltages VCG1, VCG2, VCG3 output by the MUX selector 524 may be the same or different from each other, depending on the requirements of the design. The difference between the low voltage supply voltage (VDD) and the high voltage supply voltage (nVDD) determines the choice of each of the control voltages VCG1, VCG2, VCG3, which may be the same or different from each other.

The core circuit LS_CORE 510 includes an input portion 530, coupled between a low voltage supply line (VDD) and ground (GND) and comprising two input nodes 532, 534, a PMOS transistor 536 and an NMOS transistor 538. The first input node 532 is arranged to receive an input signal IN from a low voltage (VDD) domain, and the second input node 534 is configured to provide a second input signal INB. The PMOS transistor 536 has a source coupled to the low voltage supply line VDD, a gate coupled to receive the input signal IN from the first input node 532, and a drain coupled to the second input node 534. The NMOS transistor 538 has a drain coupled to the second input node 534, a source coupled to the ground GND, and a gate coupled to receive the input signal IN from the first input node 532.

The first input signal IN has a first state (e.g., logic level "0") corresponding to the ground potential GND and a second state (e.g., logic level "1") corresponding to the potential of the low voltage supply line VDD. The second input signal INB generated at the second input node 534 accordingly has a respective first state corresponding to the potential of the low voltage supply line VDD and a respective second state corresponding to the potential of the ground GND.

The core circuit LS_CORE 510 further comprises two first output nodes 540, 542, for outputting a two first output signals OUT1 and OUT1B respectively, and two second output nodes 544, 546, for outputting a two second output signals OUT2 and OUT2B respectively.

The core circuit LS_CORE 510 further comprises a first pair of cross-coupled semiconductor devices 550, 552, each in the form of an ST-PMOS device 400, a second pair of semiconductor devices 560, 562, each in the form of an ST-PMOS device 400, and a third pair of semiconductor devices 570, 572, each in the form of an ST-NMOS device 300.

Each of the first pair of (ST-PMOS) semiconductor devices 550, 552 has a source terminal (S) connected to the high-voltage supply line 2VDD. A first one 550 of the first pair of (ST-PMOS) semiconductor devices 550, 552 has a drain terminal (D) connected to a first one OUT1 540 of the two first output nodes, and a gate terminal (G) connected to the other one OUT1B 542 of the two first output nodes. A second one 552 of the first pair of (ST-PMOS) semiconductor devices 550, 552 has a drain terminal (D) connected to a second one OUT1B 542 of the two first output nodes, and a gate terminal (G) connected to the first one OUT1 540 of the two first output nodes. The gate-control terminal (CG) of each of the first pair of (ST-PMOS) semiconductor devices 550, 552 is arranged to receive the first control voltage VCG1 525 output by the control circuit CG_CTRL 520.

Each of the second pair of (ST-PMOS) semiconductor devices 560, 562 has a gate terminal (G) connected to the gate terminal (G) of the other one of the second pair of (ST-PMOS) semiconductor devices 560, 562. The source terminal (S) of the first one 560 of the second pair of (ST-PMOS) semiconductor devices 560, 562 is connected to the first one OUT1 540 of the two first output nodes 540, 542. The source terminal (S) of the second one 562 of the second pair of (ST-PMOS) semiconductor devices 560, 562 is connected to the second one OUT1B 542 of the two first output nodes 540, 542. The drain terminal (D) of the first one 560 of the second pair of (ST-PMOS) semiconductor devices 560, 562 is connected to the first one OUT2 544 of the two second output nodes 544, 546. The drain terminal (D) of the second one 562 of the second pair of (ST-PMOS) semiconductor devices 560, 562 is connected to the second one OUT2B 546 of the two second output nodes 544, 546. The gate-control terminal (CG) of each of the second pair of (ST-PMOS) semiconductor devices 560, 562 is connected to the gate terminal (G) of the respective ST_PMOS device 560, 562, and is arranged to receive the second control voltage VCG2 526 output by the control circuit CG_CTRL 520.

Each of the third pair of (ST-NMOS) semiconductor devices 570, 572 has a source terminal (S) connected to the ground GND. The first one 570 of the third pair of (ST-NMOS) semiconductor devices 570 has a drain terminal (D) connected to the first one OUT2 544 of the two second output nodes 544, 546, and a gate terminal (G) arranged to receive the second input signal INB 534 from the input portion 530. The second one 572 of the third pair of (ST-NMOS) semiconductor devices 570, 572 has a drain terminal (D) connected to the second one OUT2B 546 of the two second output nodes 544, 546, and a gate terminal (G) arranged to receive the first input signal IN 532. The gate-control terminal (CG) of each of the third pair of (ST-NMOS) semiconductor devices 570, 572 is arranged to receive the third control voltage VCG3 527 output by the control circuit CG_CTRL 520.

The level shifter 500 supports a dual-mode output. This is illustrated in the lower portion of Figure 5, which shows the behaviour of level shifter 500 in terms of the first and second input signals IN and INB, at the respective input nodes 532, 534, the first output signals OUT1 and OUT1B at the respective first output nodes 540, 542, and the second output signals OUT2 and OUT2B at the respective second output nodes 544, 546. To support the dual-mode output, the control voltage VCG1 may be connected to a voltage VDD or 2VDD/2. The control voltages VCG2 and VCG3 may be connected to VDD, although alternatives are possible.

Then, in the first state, IN=0 (GND), such that INB=VDD. As result, the first one 570 of the third pair of (ST_NMOS) semiconductor devices turns on, and the second one 572 of the third pair of (ST_NMOS) semiconductor devices turns off. From the point of view of the first pair of (ST-PMOS) semiconductor devices 550, 552, the second pair of (ST-PMOS) semiconductor devices 560, 562 act as a voltage clamp. For this reason, the signals at the two first output nodes 540, 542 are respectively given by OUT1=VCG2+|VTH-P|, where |VTH_P| is the threshold voltage of the PMOS transistor, and OUT1B=2VDD. Because the first one 570 of the third pair of (ST_NMOS) semiconductor devices turns on, the signal at the first one 544 of the two second output nodes is given by OUT2=GND+δ≈0, where δ represents non-ideal factors and is generally sufficiently small that it can be neglected. Because the second one 552 of the first pair of (ST_PMOS) semiconductor devices and the second one 562 of the second pair of (ST_PMOS) semiconductor devices turn on, the signal at the second one 546 of the two second output nodes is given by OUT2B=2VDD-δ≈2VDD.

Similarly, in the second state, IN=VDD, such that INB=0. As result, the first one 570 of the third pair of (ST_NMOS) semiconductor devices turns off, and the second one 572 of the third pair of (ST_NMOS) semiconductor devices turns on. With the second pair of (ST-PMOS) semiconductor devices 560, 562 acting as a voltage clamp, the signals at the two first output nodes 540, 542 are respectively given by OUT1=2VDD and OUT1B=VCG2+|VTH_P|, where |VTH_P| is the threshold voltage of the PMOS transistor. Because the second one 572 of the third pair of (ST_NMOS) semiconductor devices turns on, the signal at the second one 546 of the two second output nodes is given by OUT2B=GND+δ≈0. Because the first one 550 of the first pair of (ST_PMOS) semiconductor devices and the first one 560 of the second pair of (ST_PMOS) semiconductor devices turn on, the signal at the first one 544 of the two second output nodes is given by OUT2=2VDD-δ≈2VDD.

Accordingly, the level shifter 500 of Figure 5 supports the following two modes:
- Mode 1: logic "0" coverts from GND to (n-1)VDD, and logic "1" converts from VDD to nVDD; this mode being provided by the output signals OUT1 and OUT1B at the two first output nodes 540, 542; and
- Mode 2: logic "0" coverts from GND to GND, and logic "1" converts from VDD to nVDD; this mode being provided by the output signals OUT2 and OUT2B at the two second output nodes 544, 546.

By supporting the two different modes given above, the level shifter 500 is able to support different interfaces through a single design.

In particular, because each of the semiconductor devices 550, 552, 560, 562, 570, 572 is provided in the form of a stress-tolerant ST-NMOS device 300 or a ST-PMOS devices 400, the level shifter 500 is able to support Mode 2 above without any voltage stress risk.

In addition to providing the dual-mode output described above, the design of the level shifter 500 has the flexibility to allow the level shifter 500 to be adapted to other applications. For example, consider an application in which a 2VDD interface is not required, that is, only a VDD interface is required. To support a 1VDD interface (n=1), the control voltages VCG1 and VCG2 are connected to GND, and the control voltage VCG3 is connected to VDD. In this case, all the semiconductor devices 550, 552, 560, 562, 570, 572 act as switchers and the level shifter will work as in the normal design. Accordingly, the level shifter 500 may also be used to interface between VDD and 1VDD domains.

Figure 6 schematically illustrates a level shifter 600 according to another example embodiment of the present disclosure. Elements of level shifter 600 which are identical to those of level shifter 500 of Figure 5 are labelled with the same reference numbers. The core circuit LS_CORE 610 of level shifter 600 differs from the core circuit LS_CORE 510 of level shifter 500 in that the first pair of cross-coupled semiconductor devices 650, 652 are provided in the form of standard PMOS transistors 650, 652, rather than stress-tolerant PMOS semiconductor devices 550, 552. Each of the cross-coupled PMOS transistors 650, 652 has a source connected to the high-voltage supply line 2VDD. A first one 650 of the cross-coupled PMOS transistors 650, 652 has a drain connected to a first one OUT1 540 of the two first output nodes, and a gate connected to the other one OUT1B 542 of the two first output nodes. A second one 652 of the cross-coupled PMOS transistors 650, 652 has a drain connected to a second one OUT1B 542 of the two first output nodes, and a gate connected to the first one OUT1 540 of the two first output nodes. As shown in the lower portion of Figure 6, the level shifter 600 provides the same dual-mode outputs OUT1, OUT1B, OUT2, OUT2B as the level shifter 500 of Figure 5. An advantage of the level shifter 500 is that it requires less area. However, the control voltage VCG2 must be carefully controlled to ensure that there is no voltage stress at the first output nodes OUT1, OUT1B.

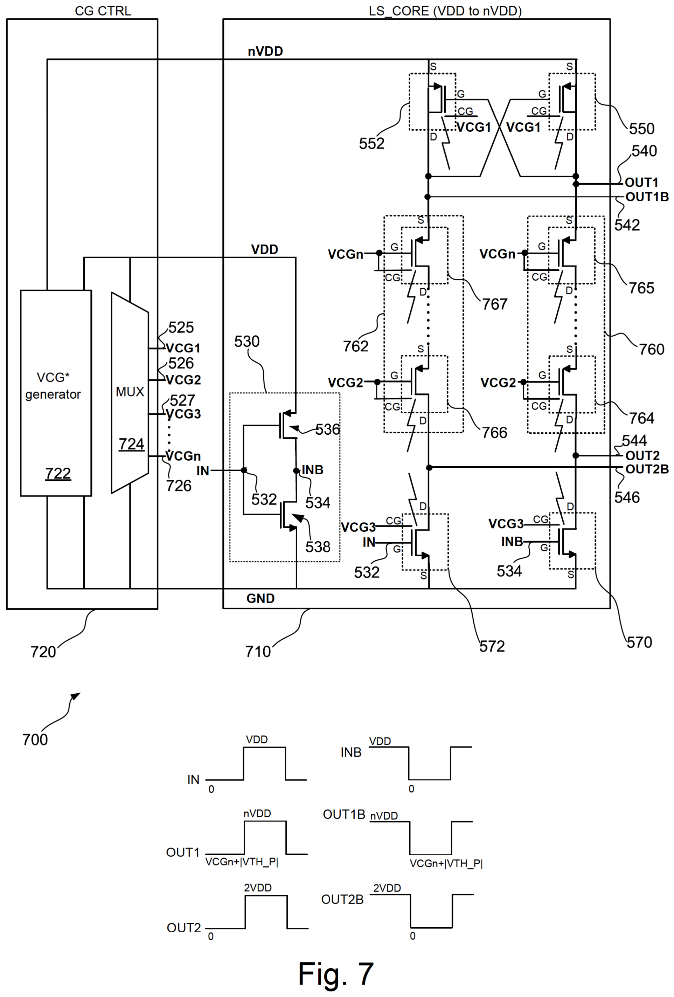

Figure 7 schematically illustrates a level shifter 700 according to a further example embodiment of the present disclosure, for level shifting from VDD to nVDD domains, where n>2. Elements of level shifter 700 which are identical to those of level shifter 500 of Figure 5 are labelled with the same reference numbers. The core circuit LS_CORE 710 of level shifter 700 differs from the core circuit LS_CORE 510 of level shifter 500 in that the second pair of semiconductor devices 760, 762, are provided in the form of an n-stack of series-coupled ST-PMOS devices 400, rather than the single stress-tolerant PMOS semiconductor devices 550, 552 of Figure 5. That is, each one of the second pair of semiconductor devices 760, 762 comprises a respective plurality of n stress-tolerant PMOS devices 764 ... 765 and 766...767, coupled in series between the respective first output node OUT1 540, OUT1B 542 and the respective second output node OUT2 544, OUT2B 546. The drain terminal of each one of the second pair semiconductor devices 760, 762 is provided by the drain terminal (D) of a first one 764, 766 of the respective plurality or n-stack of stress-tolerant devices 764 ... 765, 766...767. The drain terminal (D) of each next (or ith) one 765,767 of the respective plurality of stress-tolerant devices is coupled to the source terminal (S) of the respective preceding (or (i-1)th) one 764, 766 of the respective plurality of stress-tolerant devices. The source terminal of each one of the second pair semiconductor devices 760, 762 is provided by the source terminal (S) of a last (or nth) one 765, 767 of the respective plurality of stress-tolerant devices 764...765, 766...767. The gate (G) and gate-control (CG) terminals of every ST_PMOS device 764...765 and 766...767 comprised in the pair of second semiconductor devices 760, 762 is controlled by the control circuit 720. More specifically, the gate terminal (G) of each stress-tolerant PMOS device 764...765, 766...767 of each one of the second pair of semiconductor devices 760, 762 is coupled to the gate-control terminal of the same stress-tolerant device 764...765, 766...767. The gate terminal (G) of each one of the plurality of stress-tolerant PMOS devices 764...765 of one 760 of the second pair of semiconductor devices 760, 762 is coupled to the gate terminal (G) of a corresponding stress-tolerant PMOS device 766...767 of the other one 762 of the second pair of semiconductor devices 760, 762, and is configured to receive a respective gate-control voltage VCG2...VCGn from the control circuit 720. The VCG generator 722 and MUX selector 724 of the level shifter 700 of Figure 7 differ from the VCG generator 522 and MUX selector 524 of the level shifter 500 of Figure 5 in that the VCG generator 722 generates further control voltages as required and the MUX selector outputs further control voltages VCGn 726 to the core circuit LS_CORE 710. The control voltages VCG1/2/3...n are determined based on the voltage difference between the high voltage supply line nVDD and the low voltage supply line VDD, and are chosen to keep the terminal-to-terminal voltages (i..e, Vds, Vgd, Vgs) of each transistor less than one VDD. For example, the voltages VCG1 and VCGn may be set to (n-1)VDD (i.e., to a difference between the high voltage supply nVDD and the low voltage supply VDD), while the voltages VCG2 and VCG3 may be set to VDD i.e. the voltage of the low voltage supply. For any intervening ST-PMOS devices in the stack 760 between the ST-PMOS devices 764 and 765, or in the stack 762 between the ST-PMOS devices 766 and 767 respectively, the respective control voltages VCGx would take the values from 2VDD to (n-2)VDD from bottom to top. The lower portion of Figure 7 shows the behaviour of level shifter 700 in terms of the first and second input signals IN and INB, the first output signals OUT1 and OUT1B at the respective first output nodes 540, 542, and the second output signals OUT2 and OUT2B at the respective second output nodes 544, 546. For an input signal having voltages 0 (logic "0") and VDD (logic "1"), the first output signal OUT1 at the first output node 540 has the voltages VCGn+|VTH_P| and nVDD, where VCGn is the voltage applied to the control gate (CG) of the last ST-PMOS device 765, 767 in the respective stack of ST-PMOS devices 764...765, 766...767 of the respective second semiconductor device 760, 762. For the same input signal having voltages 0 (logic "0") and VDD (logic "1"), the second output signal OUT2 has the values 0 and 2VDD respectively.

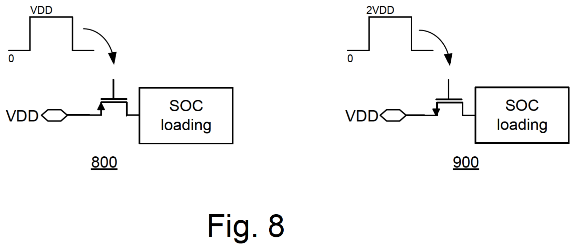

Figure 8 illustrates an example application of the output signals OUT2, OUT2B of the dual mode level shifters 500, 600, 700 of Figures 5, 6, and 7, in the form of a power switch. At the MCU level, more and more power switches are to be used, and the loading requirements become more and more challenging. A key function of the power switch is to drive a high current while, to avoid a large IR drop, the turn-on resistance should be as small as possible. In addition, to reduce power consumption, the turn-on/turn-off leakage should be as small as possible. The left-hand side of Figure 8 illustrates an example power switch 800, useful for understanding the present disclosure, in which a signal from the VDD domain is used to control the gate of a PMOS power transistor. When the gate signal is 0, the PMOS switch 800 is on; when the gate signal is VDD, the PMOS switch 800 is off. The die size and leakage (both channel leakage and bulk leakage) may be undesirably large. The right-hand side of Figure 8 illustrates a power switch 900 according to an example embodiment of the present disclosure, in which a signal from the nVDD domain is used to control the gate of an NMOS power transistor. The NMOS power transistor is coupled between a low voltage power supply VDD and a load ("SOC loading"). The gate signal may be provided by one of the two second outputs OUT2, OUT2B of the level shifter 500 of Figure 5, the level shifter 600 of Figure 6, or the level shifter 700 of Figure 7, and therefore may have a first state corresponding to the ground GND, and a second state corresponding to the high voltage supply nVDD. As an example, the gate signal for the power switch 900 is shown having the states 0V and 2VDD. When the gate signal is 0, the NMOS switch 900 is off. When the gate signal is 2VDD, the NMOS switch 900 is on, while the gate-source voltage Vgs and the gate-drain voltage Vgd are both VDD (no voltage stress). Advantageously, for a bulk process, same size, the PMOS turn-on resistance Ron_PMOS may be about three times larger than the NMOS turn-on resistance Ron_NMOS. Using one of the second output signal OUT2 or OUT2B to control an NMOS power transistor may therefore expect to obtain the same performance while saving around 2/3 of the die area. For an SOI process, while using "sub selection solution" the saved die area will be very noticeable. The leakage, determined by Vbs=-VDD for the NMOS power switch 900 will be lower than the leakage for the PMOS power switch 800, which is determined by Vbs=0V. Accordingly, the level shifter of the present disclosure may be used for driving the gate of an NMOS power switch.

In view of the above, it can be seen that the present disclosure provides a level shifter which uses a standard VDD digital process and provides stress-tolerant VDD to nVDD conversion with a dual-mode output. The design can be used in all processes and with different power combinations. Individual control of the control voltages of the stress-tolerant semiconductor devices comprised in the level shifter means a single design can flexibly support multiple different applications. Compared to other stress-tolerant level shifters, the level shifter disclosed herein provides high compatibility, high flexibility and small size. Since it does not require any clock or other peripheral, the solution provided is a continuous-time level shift controller. The dual mode output is particularly important for power switch design.

Accordingly, a level shifter 500, 600, 700 has been disclosed above, the level shifter 500, 600, 700 comprising: two input nodes 532, 534; two first output nodes 540, 542; two second output nodes 544, 546; a first pair of cross-coupled semiconductor devices 550, 552, 650, 652 each having a source terminal (S) coupled to a high-voltage supply nVDD, each having a drain terminal (D) coupled to a respective one of the two first output nodes 540, 542, and each having a gate terminal (G) coupled to a respective other of the two first output nodes 540, 542; a second pair of semiconductor devices 560, 562, 760, 762 each having a source terminal (S) coupled to a respective one of the two first output nodes 540. 542, and each having a drain terminal (D) coupled to a respective one of the two second output nodes 544, 546; and a third pair of semiconductor devices 570, 572, each having a drain terminal (D) coupled to a respective one of the two second output nodes 544, 546, each having a source terminal (S) coupled to a reference potential GND, and each having a gate terminal (G) coupled to a respective one of the two input nodes 532, 534; wherein each one of the second pair of semiconductor devices 560, 562, 760, 762 and each one of the third pair of semiconductor devices 570, 572 comprises at least one stress-tolerant device 300, 400 as disclosed above. In the example embodiments of the level shifter 500, 600, 700 shown in Figures 5 to 7, each of the third pair of semiconductor devices 570, 572 is provided by a stress-tolerant NMOS device 300. In the example embodiments of the level shifter 500, 600 shown in Figures 5 to 6, each of the second pair of semiconductor devices 560, 562 is provided by a stress-tolerant PMOS device 400, while in the example embodiment of the level shifter 700 shown in Figure 7, each of the second pair of semiconductor devices 760, 762 is provided by a series-coupled stack 764...765, 766...767 of stress-tolerant PMOS devices 400. In the example embodiments of the level shifter 500, 700 shown in Figures 5 and 7, each of the first pair of semiconductor devices 550, 552 is provided by a stress-tolerant PMOS device 400, while in the example embodiment of the level shifter 600 shown in Figure 6, each of the first pair of semiconductor devices 650, 652 is provided by a PMOS transistor.

It will be readily understood that the components of the embodiments as generally described herein and illustrated in the appended figures could be arranged and designed in a wide variety of different configurations. Thus, the foregoing more detailed description of various embodiments, as represented in the figures, is not intended to limit the scope of the present disclosure, but is merely representative of various embodiments. While the various aspects of the embodiments are presented in drawings, the drawings are not necessarily drawn to scale.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. A stress-tolerant semiconductor device, comprising:
a source terminal, a gate terminal, a gate-control terminal, and a drain terminal;
a first transistor having a source connected to the source terminal of the stress-tolerant device, a gate connected to the gate terminal of the stress-tolerant device, and a drain;
a second transistor having a source connected to the drain of the first transistor, a gate connected to the gate-control terminal of the stress-tolerant device, and a drain;
a third transistor having a source connected to the drain of the second transistor, a drain connected to the drain terminal of the stress-tolerant device, and a gate;
a fourth transistor having a drain connected to the gate-control terminal of the stress-tolerant device, a gate connected to the drain terminal of the stress-tolerant device, and a source; and
a fifth transistor comprising a source connected to the source of the fourth transistor, a gate connected to the gate-control terminal of the stress-tolerant device, and a drain connected to the drain terminal of the stress-tolerant device;
wherein a conductivity type of said first, second and third transistors is opposite to a conductivity type of said fourth and fifth transistors.

2. A level shifter comprising at least one stress-tolerant semiconductor device according to claim 1.

3. A level shifter according to claim 2, comprising:
two input nodes;
two first output nodes;
two second output nodes;
a first pair of cross-coupled semiconductor devices, each having a source terminal coupled to a high-voltage supply, each having a drain terminal coupled to a respective one of the two first output nodes, and each having a gate terminal coupled to a respective other of the first two output nodes;
a second pair of semiconductor devices each having a source terminal coupled to a respective one of the two first output nodes, and each having a drain terminal coupled to a respective one of the two second output nodes; and
a third pair of semiconductor devices, each having a drain terminal coupled to a respective one of the two second output nodes, each having a source terminal coupled to a reference potential, and each having a gate terminal coupled to a respective one of the two input nodes;
wherein each one of the second pair of semiconductor devices and each one of the third pair of semiconductor devices comprises at least one stress-tolerant device according to claim 1.

4. A level shifter according to claim 3, wherein each one of the second pair of semiconductor devices comprises a plurality of stress-tolerant devices according to claim 1,
wherein the drain terminal of each one of the second pair semiconductor devices is provided by the drain terminal of a first one of the respective plurality of stress-tolerant devices;
wherein the drain terminal of each next one of the respective plurality of stress-tolerant devices is coupled to the source terminal of the respective preceding one of the respective plurality of stress-tolerant devices;
wherein the source terminal of each one of the second pair semiconductor devices is provided by the source terminal of a last one of the respective plurality of stress-tolerant devices.

5. A level shifter according to claim 3 or claim 4, wherein the gate terminal of each said at least one stress-tolerant device of each of said second pair of semiconductor devices is coupled to the gate-control terminal of the respective stress-tolerant device.

6. A level shifter according to any one of claims 3 to 5, wherein the gate terminal of each one of said at least one stress-tolerant device of one of said second pair of semiconductor devices is coupled to the gate terminal of a corresponding stress-tolerant device of the other one of said second pair of semiconductor devices.

7. A level shifter according to any one of claims 3 to 6,
wherein the first, second and third transistors of each said stress-tolerant device of the second pair of semiconductor devices are PMOS transistors, and said fourth and fifth transistors of each said stress-tolerant device of the second pair of semiconductor devices are NMOS transistors; and/or
wherein said first, second and third transistors of each said stress-tolerant device of the third pair of semiconductor devices are NMOS transistors, and said fourth and fifth transistors of each said stress-tolerant device are PMOS transistors.

8. A level shifter according to any one of claims 3 to 7,
wherein each one of the first pair of semiconductor devices comprises a stress-tolerant device according to claim 1.

9. A level shifter according to claim 8,
wherein the first, second and third transistors of each said stress-tolerant device of the first pair of semiconductor devices are PMOS transistors, and said fourth and fifth transistors of each said stress-tolerant device of the first pair of semiconductor devices are NMOS transistors.

10. A level shifter according to any one of claims 3 to 7,
wherein each one of the first pair of semiconductor devices is a PMOS transistor.

11. A level shifter according to any one of claims 3 to 10, further comprising:
an input circuit coupled between a low voltage supply and the reference potential, configured to receive a first input signal having a first state corresponding to the reference potential and a second state corresponding to the potential of the low voltage supply, and to generate a second input signal having a respective first state corresponding to the potential of the low voltage supply and a respective second state corresponding to the reference potential,
wherein one of said two input nodes is arranged to receive the first input signal, and the other one of said two input nodes is configured to receive the second input signal.

12. A level shifter according to any one of claims 3 to 11,
further comprising a control circuit for generating one or more control voltages, wherein a respective gate-control terminal of each of said stress-tolerant semiconductor devices is arranged to receive one of said one or more control voltages, and, optionally,
further comprising a multiplexer arranged to receive said one or more control voltages, and to output a respective selected one of said one or more control voltages to the respective gate-control terminal of each said stress-tolerant semiconductor devices.

13. A level shifter according to any one of claims 3 to 12,
wherein the gate-control terminal of each one of the first pair of semiconductor devices is arranged to receive a voltage corresponding to a difference between the voltage of the high voltage supply and the voltage of the low voltage supply; and/or
wherein at least one respective gate-control terminal of each one of the second pair of semiconductor devices and/or the third pair of semiconductor devices is arranged to receive a voltage corresponding to the low voltage supply.

14. A level shifter according to any one of claims 3 to 13, wherein the respective gate-control terminal of each one of the first pair of semiconductor devices and/or at least one gate-control terminal of the each one of the second pair of semiconductor devices is coupled to the reference potential, and/or wherein the respective gate-control terminal of each one of the third pair of semiconductor devices is arranged to receive a voltage corresponding to the low voltage supply.

15. A power switch comprising:
An NMOS power transistor; and
a level shifter according to any one of claims 3 to 14,
wherein a gate of the power transistor is coupled to one of the two second output nodes.
